# EUROPEAN PATENT APPLICATION

(11) **EP 1 523 036 A2**
(43) Date of publication of application: **13.04.2005**
(21) Application number: 04077669.2
(22) Date of filing: 28.09.2004
(51) Int. Cl.: H01L 23/367, H01L 25/065

(54) **Semiconductor device heat sink package and method**

(30) Priority: 10.10.2003 US 683009
(71) Applicant: Delphi Technologies, Inc., Troy, MI 48007 (US)
(72) Inventor: Mandel, Larry M., Nolesville, IN 46060 (US); Sarma, Dwadasi H., Kokomo, IN 46902 (US); Gertiser, Kevin M., Noblesville, IN 46060 (US); Zimmerman, David W., Fishers, IN 46038 (US); Chengalva, Suresh K., Kokomo, IN 46902 (US)
(74) Representative: Denton, Michael John

(57) **Abstract**

An electronic package (10) having enhanced heat dissipation is provided exhibiting dual conductive heat paths (40, 42) in opposing directions. The package (10) includes a substrate (18) and a semiconductor device (12) mounted to the substrate (18). The semiconductor device (12) has electrical circuitry a first surface, and a second surface oppositely disposed from the first surface. A thermally conductive heat sink (30) is assembled over the semiconductor device (12) such that a cavity (32) is formed between the semiconductor device (12) and the heat sink (30). A thermally conductive and electrically insulative material (36) is disposed in the cavity (32) between the semiconductor device (12) and the heat sink (30).

## Description

### Technical Field

The present invention generally relates to heat generating semiconductor devices and, more particularly, to a semiconductor device and heat sink assembly for dissipating heat away from the semiconductor device.

### Background of the Invention

Electronic packages, such as electronic control modules, generally contain fabricated electrical circuitry including electronic components such as transistors and resistors. The circuitry conducts electrical current which, in turn, generates thermal energy (i.e., heat) within the electronic package. Excessive heat build-up within certain electronic packages and other components within a module may lead to adverse effects including electrical circuit failure. Thus, it is desirable to dissipate heat away from the electronic package.

Many electronic packages employ semiconductor devices in the form of a flip chip or Insulated Gate Bipolar Transistor (IGBT) chip and wire device. Some conventional techniques for dissipating thermal energy from the electronic package employ a thermally conductive heat sink supported in contact with the package via clamps, or directly mount the heat sink onto a printed circuit board. One approach for conducting heat from a flip chip semiconductor device is disclosed in U.S. Patent No. 6,180,436, the entire disclosure of which is hereby incorporated herein by reference. The aforementioned approach employs a flip chip mounted on a flexible substrate, having a heat-conductive member brought into thermal contact with one surface of the flip chip, and a biasing member for biasing the one surface of the flip chip against the heat-conductive member.

While conventional approaches generally suffice to dissipate some of the thermal energy (heat) away from the semiconductor device, many approaches do not offer optimal heat dissipation. For example, many approaches achieve a substantial amount of heat dissipation in one general direction, primarily by placing a heat sink in thermal contact with one surface of the semiconductor device. While some additional heat dissipation may be achieved in other directions through air or some other medium exhibiting poor thermal conductivity, such heat dissipation is generally minimal. The resultant heat dissipation realized in many conventional semiconductor packages results in size and power limitations.

Accordingly, it is therefore desirable to provide for a semiconductor device and heat sink package and method of dissipating thermal energy (heat) away from the semiconductor device in an optimal manner.

### Summary of the Invention

According to one aspect of the present invention, an electronic package having enhanced heat dissipation is provided. The package includes a substrate and a semiconductor device mounted to the substrate. The semiconductor device has electrical circuitry, a first surface, and a second surface oppositely disposed from the first surface. A thermally conductive heat sink is assembled over the semiconductor device such that a cavity is formed between the semiconductor device and the heat sink. A thermally conductive and electrically insulative material is disposed in the cavity between the semiconductor device and the heat sink.

According to a further aspect of the present invention, a method of conducting heat from a semiconductor device is provided. The method includes the steps of providing a substrate and mounting a semiconductor device to the substrate. The semiconductor device has electrical circuitry, a first surface, and a second surface oppositely disposed from the first surface. The method further includes the steps of assembling a thermally conductive heat sink over the first surface of the semiconductor device so as to form a cavity between the semiconductor device and the heat sink, and disposing a thermally conductive and electrically insulative material within the cavity formed between the semiconductor device and the heat sink.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a perspective view of an electronic package containing semiconductor device and heat sink assemblies;
FIG. 2 is a cross-sectional view taken through lines II-II in FIG. 1 illustrating a semiconductor device and heat sink assembly according to a first embodiment of the present invention;
FIG. 3 is a cross-sectional view taken through a flip chip semiconductor device and heat sink assembly according to a second embodiment of the present invention; and
FIG. 4 is a cross-sectional view of a flip chip semiconductor device and heat sink assembly according to a third embodiment of the present invention.

### Description of the Preferred Embodiments

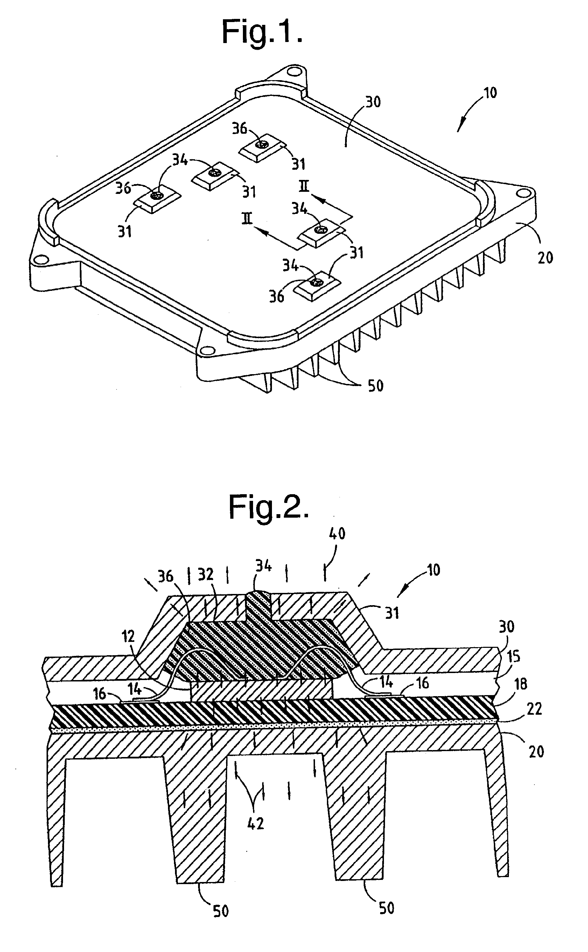

Referring to FIG. 1, an electronic package 10 is generally illustrated having a lower case 20 and an upper cover 30 forming an enclosure containing electrical circuitry. The electronic package 10 may be employed as an electronic control module (ECM) for use on a vehicle, according to one example. The electronic package 10 has a plurality of semiconductor devices mounted onto one or more circuit boards within the enclosure. In the example shown, the electronic package 10 includes a plurality of semiconductor devices mounted to a substrate; however, it should be appreciated that one or more semiconductor devices may be mounted on one or more substrates and arranged in a thermally (heat) conductive relationship with one or more heat sinks according to the present invention. While the electronic package 10 is shown substantially enclosed, it should be appreciated that package 10 may be otherwise configured with the semiconductor device(s) not enclosed within a surrounding case and cover.

Referring to FIG. 2, a portion of the electronic package 10 is shown according to a first embodiment including a chip and wire semiconductor device 12 in conductive heat transfer relationship with the case 20 and cover 30. The electronic package 10 includes a semiconductor device in the form of a chip and wire device, according to the first embodiment, mounted on the upper surface of substrate 18. The substrate 18 has electrical conductors, including contact pads 16, formed on the upper surface. Electrical conductors may also extend across the upper surface and/or through substrate 18. The semiconductor device 12 has a first surface on the upper side, and a second surface oppositely disposed from the first surface on the bottom side. Wire leads 14 extend from the top surface of semiconductor device 12 to contact pads 16 formed on the top surface of substrate 18.

The semiconductor device 12 is a power dissipating semiconductor device generally having electrical circuitry, such as integrated circuitry, intended to conduct electrical current. For example, the semiconductor device 12 may include one or more transistors configured to provide a controlled switching operation, operate as a diode, or provide voltage regulation. When electrical current passes through the electrical circuitry in the semiconductor device 12, thermal energy (heat) is typically generated within the semiconductor device 12 due to electrical resistance. Semiconductor device 12 may include any of a number of electronic devices including, but not limited to, chip and wire insulated gate bipolar transistor (IGBT) devices, application specific integrated circuit (ASIC) devices, and flip chips.

The substrate 18 may include any known substrate material, such as FR4 or ceramic material, and may be provided as a laminated circuit board, such as a printed circuit board having printed circuitry as is generally known in the art. Alternately, the substrate 18 may be provided as a wiring board. It should be appreciated that the substrate 18 may include electrical circuitry formed on the top surface thereof and extending therethrough, including circuitry formed in intermediate layers and on the bottom surface. The substrate 18 may be formed of a rigid or flexible material. It is also contemplated that substrate 18 may have electrical circuitry formed on the bottom surface and a recessed cavity to allow placement of one or more semiconductor devices and the bottom surface. The substrate 18 may further include one or more conductive vias extending therethrough to further enhance the conduction of heat through substrate 18.

Attached to the bottom surface of substrate 18 is the case 20, which is a thermally conductive member that may be made of a die cast metal. The die cast case 20 may be made of any suitable thermally conductive material such as an aluminum alloy (e.g., aluminum alloy 380). The die cast case 20 is shown having a plurality of upstanding cooling fins 50, generally made of the same thermally conductive material as the die cast case 20. The die cast case 20 transmits thermal energy (heat) received from the semiconductor device 12 to the surrounding environment. The cooling fms 50 provide a large surface area for dispensing the thermally energy (heat) to a fluid (e.g., air) in the surrounding environment by way of convection.

The die cast case 50 is adhered to the bottom surface of substrate 18 via a thermally conductive substrate interface material 22, such as a thermally conductive adhesive. One example of a substrate interface adhesive material 22 is Acrylic very high bond adhesive F 9469PC, commercially available from 3M. Another example of a suitable thermal tape is Thermattach T413, commercially available from Chomerics, a Division of Parker Hannifin Corporation. Other examples of suitable adhesives include T3033, commercially available from Isola Transtherm, and 1-4174 dispensable adhesive commercially available from Dow Corning Corp.

Disposed in heat transfer relationship with the upper surface of semiconductor device 12 is the cover 30 in the form of a stamped metal heat sink. Heat sink 30 is in heat transfer relationship with the upper surface of chip and wire semiconductor device 12, separated by a thermally conductive and electrically insulative material 36. The stamped metal heat sink 30 may be formed as a metal cover which, according to one embodiment, may be rigidly attached to the die cast case 20, however, the heat sink 30 and die cast case 20 may alternately be attached to the electronic package 10.

The heat sink 30 is formed by stamping sheet metal, such as aluminum alloy 5052, to form an upstanding pedestal 31 having a cavity 32 formed in the bottom surface. The cavity 32 is formed adjacent to and in the region above the semiconductor device 12. The cavity 32 has a clearance height sufficient to receive wire leads 14 of chip and wire semiconductor device 12 and the thermally conductive and electrically insulative material 36.

Formed within heat sink 30 is an aperture 34 in fluid communication with cavity 32. By forming aperture 34, the thermally conductive and electrically insulative material 36 can be dispensed within cavity 32 during the assembly of electronic package 10. The thermally conductive and electrically insulative material 36 is a highly conductive heat transfer material that enhances the heat conduction and heat convection for heat removal from semiconductive device 12. The thermally conductive material 36 also is electrically insulative (dielectric) so as to electrically isolate the electric circuit elements including wire leads 14 from each other and from heat sink cover 20. The thermally conductive material 36 has enhanced thermal conductivity as compared to the air and other mediums such as conformal coatings and encapsulants (e.g., Dow 1744 or Dow 6575). Examples of the highly conductive material 36 include TC material, compacted metal/ceramic powders, phase change materials (e.g., for transients), and other materials having enhanced thermal conductivity.

The thermally conductive and electrically insulative material 36 is highly thermally conductive and electrically insulative. Examples of the thermally conductive and electrically insulative material 36 include thermally enhanced silicon adhesive (e.g., 1-4173 thermally conductive elastomer commercially available from Dow Corning Corp.), and phase change materials (e.g., PC2500, commercially available from Dow Chemical). The thermally conductive and electrically insulative material 36 may be a soft, pliable, low modulus material, capable of withstanding long term exposure to a typical automotive environment, and should remain in contact with heat sink 30 and semiconductor device 12.

The heat sink cover 30 and high thermally conductive and electrically insulative material 36 advantageously provides for an enhanced first heat dissipation conductive path 40 which transfers heat from semiconductor device 12 upwards through heat sink 30 to the surrounding environment. Additionally, the electronic package 10 has a second heat dissipation conductive path 42 which flows downward from semiconductor device 12 through substrate 18 and through die cast case 20 and cooling fins 50 to the surrounding environment from the bottom of the package 10. Thus, enhanced cooling is realized with the dual path conductive heat transfer of the present invention. The enhanced cooling achieved with the present invention eliminates costly methods required for convective heat transfer which may otherwise be required. This allows power semiconductor devices to be packaged in smaller devices and/or designed with enhanced power consumption.

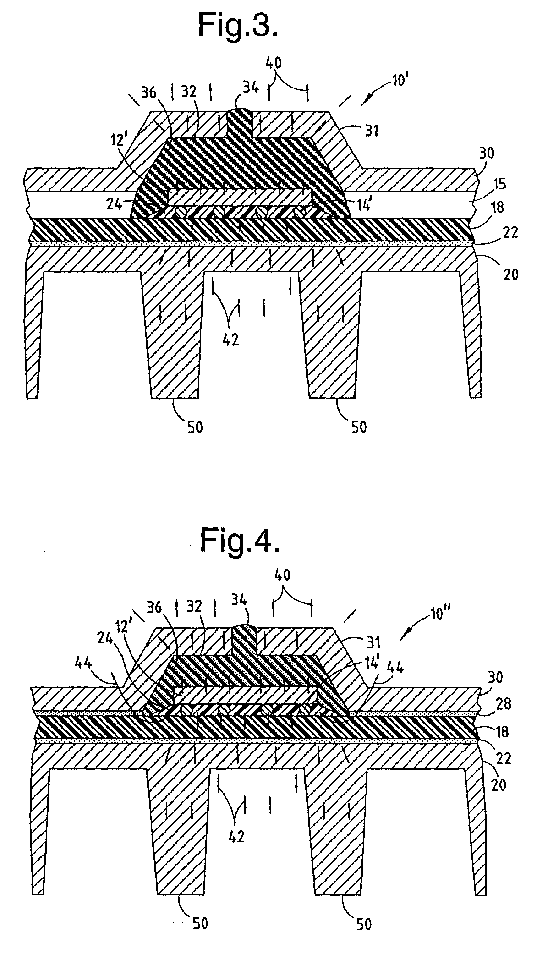

Referring to FIGS. 3 and 4, electronic packages 10' and 10" are shown including a flip chip semiconductor device 12' according to second and third embodiments, respectively. In FIG. 3, the flip chip 12' has solder bumps 14' formed on a lower surface which, in turn, contacts electrical conductors on substrate 18. The flip chip 12' also has an upper surface in contact with the thermally conductive and electrically insulative material 36 which is generally contained within cavity 32 of heat sink 30. Surrounding solder bumps 14' and disposed between the lower surface of flip chip 12' and upper surface of substrate 18 is a dielectric underfill material 24. The underfill material 24 is an electrically non-conductive dielectric material, such as polymeric material, used to promote the thermal cycle life of the solder bumps 14' . The underfill material 24 may include an epoxy resin, according to one example.

In the embodiment shown in FIG. 3, the flip chip 12' is in heat transfer relationship with the heat sink 30 via thermally conductive and electrically insulated material 36. The flip chip 12' is also in heat transfer relationship with die cast case 20. Surrounding flip chip 12' is an air gap 15 between heat sink 30 and die cast case 20. The air gap 15 may or may not be filled with a thermally conductive material.

Referring to FIG. 4, an electronic package 10" is illustrated having the flip chip semiconductor device 12' as shown and described above in connection with FIG. 3. In the embodiment of FIG. 4, the heat sink 30 is adhered to substrate 18 via a thermally conductive material 28. The thermally conductive material 28 may include any of a number of thermally conductive adhesives such as 1-4173 and 1-4174 thermally conductive adhesives, commercially available from Dow Corning Corp.

By adhering the heat sink 30 to substrate 18 via thermally conductive adhesive layer 28, enhanced heat dissipation is achieved by additional heat dissipation conductive path 44 which conducts heat from the bottom surface of flip chip 12' through substrate 18, into thermally conductive layer 28, and to the surrounding environment via heat sink 30. The additional heat dissipation conductive path 44 provides enhanced cooling, in contrast to air or other poor thermally conductive environments.

While the heat sink 30 is shown in one general configuration in conjunction with semiconductor devices, such as chip and wire devices and flip chips as shown in FIGS. 2-4, it should be appreciated that the heat sink 30 may be configured in other shapes and sizes and the semiconductor device may include any of a number of heat generating semiconductor devices. The upper surface of the stamped metal cover 30 may further include upstanding cooling fins (not shown) to further enhance the surface area for dispensing the heat via convection to the surrounding fluid environment.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. An electronic package (10) comprising:
a substrate (18);
a semiconductor device (12) mounted to the substrate (18), the semiconductor device (12) having electrical circuitry, a first surface and a second surface oppositely disposed from the first surface;
a thermally conductive heat sink (30) assembled over the semiconductor device (12) such that a cavity (32) is formed between the semiconductor device (12) and the heat sink (30); and
a thermally conductive and electrically insulative material (36) disposed in the cavity (32) between the semiconductor device (12) and the heat sink (30).

2. The package as defined in claim 1, wherein the thermally conductive and electrically insulative material (36) comprises a thermally conductive adhesive.

3. The package as defined in claim 1, wherein the thermally conductive and electrically insulative material (36) comprises a phase change material.

4. The package as defined in claim 1 further comprising an opening (34) extending through the heat sink (30), wherein the thermally conductive and electrically insulative material (36) is disposed through the opening (34) into the cavity (32).

5. The package as defined in claim 1 further comprising a case (20) in heat transfer relationship with the substrate (18), wherein the heat sink (30) comprising a cover.

6. The package as defined in claim 1 further comprising a thermally conductive member (20) disposed in thermal conductive relationship to the substrate (18), wherein the heat sink (30) provides a first heat conduction path (40) and the thermally conductive member (20) provides a second heat conduction path (42) for dissipating heat energy away from the semiconductor device (12).

7. The package as defined in claim 1, wherein the heat sink (30) comprises a stamped metal heat sink.

8. The package as defined in claim 1 further comprising a plurality of cooling fins (50).

9. The package as defined in claim 1, wherein the semiconductor device (12) comprises a chip and wire device.

10. The package as defined in claim 1, wherein the semiconductor device (12' ) comprises a flip chip.

11. A method for conducting heat from a semiconductor device (12), the method comprising the steps of:
providing a substrate (18);
mounting a semiconductor device (12) to the substrate (18), the semiconductor device (12) having electrical circuitry, a first surface, and a second surface oppositely disposed from the first surface;
assembling a thermally conductive heat sink (30) over the semiconductor device (12) so as to form a cavity (32) between the semiconductor device (12) and the heat sink (30); and
disposing a thermally conductive and electrically insulative material (36) within the cavity (32) formed between the semiconductor device (12) and the heat sink (30).

12. The method as defined in claim 11, wherein the thermally conductive and electrically insulative material (36) comprises a thermally conductive adhesive.

13. The method as defined in claim 11, wherein the thermally conductive and electrically insulative material (36) comprises a phase change material.

14. The method as defined in claim 11 further comprising the step of forming an opening (34) in the heat sink (30), wherein the thermally conductive and electrically insulative material (36) is disposed through the opening (34) into the cavity (32).

15. The method as defined in claim 11 further comprising the step of forming the heat sink (30) by stamping sheet metal to form the cavity (32).

16. The method as defined in claim 11 further comprising the steps of arranging the substrate (18) in heat transfer relationship with a thermally conductive case (20) and assembling the heat sink (30) as a cover to the case (20).

17. The method as defined in claim 11 further comprising the step of attaching a thermally conductive member (20) to the substrate (18), wherein the heat sink (30) provides a first heat conduction path (40) and the thermally conductive member (20) provides a second heat conduction path (42).

18. The method as defined in claim 11, wherein the semiconductor device (12) comprises a chip and wire device.

19. The method as defined in claim 11, wherein the semiconductor device (12') comprises a flip chip.
